# EUROPEAN PATENT APPLICATION

(11) **EP 4 550 430 A1**
(43) Date of publication of application: **07.05.2025**
(21) Application number: 22950860.1
(22) Date of filing: 19.09.2022
(51) Int. Cl.: H01L 33/62, H01L 33/08, H01L 27/15

(54) **PIXEL UNIT AND MANUFACTURING METHOD THEREFOR, MICRO DISPLAY SCREEN, AND DISCRETE DEVICE**

(30) Priority: 12.07.2022 CN 202210812458
(71) Applicant: Nuoshi Technology (Suzhou) Co., Ltd., Suzhou, Jiangsu 215000 (CN)
(72) Inventor: WANG, Yazhou, Suzhou, Jiangsu 215000 (CN)
(74) Representative: Winter, Brandl - Partnerschaft mbB
(86) International application number: PCT/CN2022/119546
(87) International publication number: WO 2024/011749

(57) **Abstract**

This application provides a pixel unit, a manufacturing method therefor, a microdisplay, and a discrete device. The pixel unit includes a backplane, a display unit, a cathode electrical connection structure, and at least one anode electrical connection structure. The display unit includes at least one device layer, the at least one device layer is vertically stacked in sequence, each of the at least one device layer includes a P-type contact layer, a pixel layer, and an N-type contact layer stacked in sequence, and the P-type contact layer is located on a side of the device layer facing the backplane; and each of the at least one anode electrical connection structure is electrically connected to the P-type contact layer of the corresponding device layer, and the cathode electrical connection structure is electrically connected to the N-type contact layer of each of the at least one device layer respectively. In the pixel unit provided in this application, at least two device layers are vertically stacked and integrated in sequence on the backplane, to realize colored display. Compared with a pixel structure arranged and integrated in a horizontal direction, the pixel unit in this application occupies smaller space in the horizontal direction, so that ultra-high-density colored Micro-LED display is realized.

## Description

### TECHNICAL FIELD

This application relates to the field of semiconductor device technologies, and in particular, to a pixel unit, a manufacturing method therefor, a microdisplay, and a discrete device.

### BACKGROUND

Micro light-emitting diodes (Micro-LED) have many advantages over existing display technologies such as liquid-crystal displays (LCD) and organic light-emitting diodes (OLED), and are widely considered as the core of next-generation display technologies, having broad application prospects in various fields such as watches, televisions, projection, virtual reality, augmented reality, and mixed reality. Such applications have new requirements on chip manufacturing, size, structure, yield, driving, and other aspects, which, however, cannot be achieved by conventional LED preparation solutions and requires high degree of integration.

In the field of Micro-LEDs, colorization is a very great challenge. Currently, mainstream Micro-LED colorization technologies include solutions such as three primary colors, color conversion, and light-combining prism. The colorization is realized basically based on three colors on a planar structure, making it a challenge to further reduce the device size and display an ultra-high-density pixel array.

The use of conventional LED chips and conventional display preparation solutions is currently compatible with Mini LEDs. However, the size and thickness of Micro-LEDs are at the micron level and are much different from those of conventional LEDs which are several hundred or thousand microns in size, and a huge number of chips are involved during use of Micro-LEDs, making it difficult to prepare Micro-LEDs by using conventional solutions. For example, a mobile phone screen with 1080P resolution has more than 2 million pixels (1920* 1080), and each pixel is formed by three sub-pixels of red, green, and blue. In other words, a mobile phone screen with 1080P resolution requires more than 6 million LEDs. For conventional LED chips, one chip is transferred per second, and it takes nearly one year to complete such a screen, resulting in extremely high costs.

Currently, there are two mainstream solutions for Micro-LED chips: mass transfer and monolithic integration. In the mass transfer solution, pick and place means similar to conventional solutions is used, but different from conventional LED solutions in which one or more chips are picked up at a time, a large number of chips are picked up and transferred at a time in the mass transfer solution. The monolithic integration solution is a solution in which metal contacts are aligned and bonded to a driver after a densely arranged LED matrix region or an entire LED array of an entire wafer is formed, and offers higher-density integration.

Currently, solutions for colorization of Micro-LED display chips mainly include mass transfer integration, horizontal display with non-aligned bonding (for example, the published Chinese patent CN110462850A), and vertical display with aligned bonding. Space waste and intra-pixel optical crosstalk problems are common in the currently disclosed technologies including mass transfer integration and horizontal display with non-aligned bonding. The space waste is reflected in the horizontal layout of three colors of red, green, and blue, indicating a loss in pixel density. In addition, vertical stack integration with aligned bonding has an extremely high alignment requirement, requires high costs, and cannot ensure alignment precision. As mentioned in some documents, when the pixel size increases or decreases by 1 µm, the alignment deviation is unacceptable during preparation of ultra-small pixels. In addition, because monochromatic devices are first prepared and there is a step difference in the devices, the array is likely to crack or break due to the step difference during bonding, affecting the yield.

Therefore, it is necessary to develop a minute-sized pixel unit with high pixel density.

### SUMMARY

An objective of this application is to provide a pixel unit, a manufacturing method therefor, a microdisplay, and a discrete device, which can realize ultra-high-density and micron-scale colored display.

To achieve the foregoing objective, according to a first aspect of this application, a pixel unit is provided, including a backplane, a display unit, a cathode electrical connection structure, and at least one anode electrical connection structure, where the display unit is arranged on the backplane, and the cathode electrical connection structure and the at least one anode electrical connection structure are respectively embedded in the display unit from a side surface away from the backplane;
the display unit includes at least one device layer, the at least one device layer is vertically stacked in sequence, each of the at least one device layer includes a P-type contact layer, a pixel layer, and an N-type contact layer stacked in sequence, and the P-type contact layer is located on a side of the device layer facing the backplane; and
each of the at least one anode electrical connection structure is electrically connected to the P-type contact layer of the corresponding device layer, and the cathode electrical connection structure is electrically connected to the N-type contact layer of each of the at least one device layer respectively.

In a preferred implementation, each of the at least one anode electrical connection structure is connected to the backplane;
the at least one anode electrical connection structure includes a first anode electrical connection structure, and the first anode electrical connection structure includes a first partial structure and a second partial structure connected in sequence;
the at least one device layer includes a first device layer, the first device layer includes a first bonding layer, a first P-type contact layer, a first pixel layer, and a first N-type contact layer stacked in sequence, and the first P-type contact layer is located on a side of the first device layer close to the backplane; and
the first partial structure is embedded in the first bonding layer and the first P-type contact layer, the second partial structure is partially embedded in the first pixel layer, and the second partial structure is electrically connected to the first P-type contact layer.

In a preferred implementation, an area of an end surface of the second partial structure is larger than an area of an end surface of the first partial structure, to form a first flange at a joint between the first partial structure and the second partial structure; and
the first flange is connected to the first P-type contact layer.

In a preferred implementation, the at least one anode electrical connection structure further includes a second anode electrical connection structure;
the display unit further includes a second device layer, the second device layer is stacked on a side surface of the first device layer away from the backplane, the second device layer includes a second bonding layer, a second P-type contact layer, a second pixel layer, and a second N-type contact layer stacked in sequence, and the second bonding layer is connected to the first pixel layer; and
the second anode electrical connection structure includes a second flange, and the second flange is connected to the second P-type contact layer.

In a preferred implementation, the second N-type contact layer is arranged directly above the first N-type contact layer.

In a preferred implementation, the first N-type contact layer is of a protruding structure, and the first N-type contact layer is embedded in the second bonding layer.

In a preferred implementation, the cathode electrical connection structure includes a third partial structure, the third partial structure is embedded in the second device layer, and an end of the third partial structure is connected to the first N-type contact layer.

**In** a preferred implementation, the cathode electrical connection structure further includes a fourth partial structure, one end of the fourth partial structure is connected to the backplane, and an other end of the fourth partial structure passes through the first device layer and is connected to the third partial structure.

**In** a preferred implementation, the second bonding layer includes a second bonding layer body and a functional layer, and the functional layer is arranged between the second bonding layer body and the first pixel layer.

**In** a preferred implementation, the at least one anode electrical connection structure further includes a third anode electrical connection structure;
the display unit further includes a third device layer, the third device layer is stacked on a side surface of the second device layer away from the first device layer, the third device layer includes a third bonding layer, a third P-type contact layer, a third pixel layer, and a third N-type contact layer stacked in sequence, and the third bonding layer is connected to the second pixel layer; and
the third anode electrical connection structure includes a third flange, and the third flange is connected to the third P-type contact layer.

In a preferred implementation, the cathode electrical connection structure further includes a fifth partial structure connected to the third partial structure, and the fifth partial structure is embedded in the third device layer;
an area of an end surface of the fifth partial structure is larger than an area of an end surface of the third partial structure, to form a fourth flange at a joint between the third partial structure and the fifth partial structure; and
the fourth flange is connected to the second N-type contact layer.

In a preferred implementation, the second N-type contact layer is of a protruding structure, and the second N-type contact layer is embedded in the third bonding layer.

In a preferred implementation, both the second bonding layer and the third bonding layer are made of transparent materials.

In a preferred implementation, the pixel unit further includes a passivation layer, the passivation layer is partially attached to outer surfaces of the display unit and the backplane, the passivation layer is partially attached between the at least one anode electrical connection structure and the display unit, and the passivation layer is partially attached between the cathode electrical connection structure and the display unit.

In a preferred implementation, the passivation layer is provided with at least one through hole, and the at least one through hole is provided between each of the at least one anode electrical connection structure and the corresponding P-type contact layer, and between the cathode electrical connection structure and the corresponding N-type contact layer.

In a preferred implementation, the passivation layer is made of a transparent insulation material.

In a preferred implementation, the first pixel layer is an AlGaInP or InGaN red-emitting compound epitaxial layer, the second pixel layer is an InGaN green-emitting compound epitaxial layer, and the third pixel layer is an InGaN blue-emitting compound epitaxy epitaxial layer.

According to a second aspect, a method for manufacturing a pixel unit is provided, including:
preparing a backplane;
vertically stacking at least one device layer in sequence on the backplane to form a display unit, where each of the at least one device layer includes a P-type contact layer, a pixel layer, and an N-type contact layer stacked in sequence, and the P-type contact layer is located on a side of the device layer facing the backplane;
performing etching inwardly from a side surface of the display unit away from the backplane to construct a cathode electrical connection channel and at least one anode electrical connection channel; and
performing metal filling on the cathode electrical connection channel and the at least one anode electrical connection channel to form a cathode electrical connection structure and at least one anode electrical connection structure, where the cathode electrical connection structure is electrically connected to the N-type contact layer of each of the at least one device layer respectively, and each of the at least one anode electrical connection structure is electrically connected to the P-type contact layer of the corresponding device layer.

In a preferred implementation, the at least one device layer includes a first device layer; and the vertically stacking at least one device layer in sequence on the backplane to form a display unit includes:
plating a bonding material on a surface of the backplane and a surface of a P-type contact layer of a prepared first compound semiconductor wafer respectively and performing bonding to form a first bonding layer; and
removing a substrate of the first compound semiconductor wafer and performing compound semiconductor thinning to expose a first N-type contact layer, where the first N-type contact layer is of a protruding structure.

In a preferred implementation, the at least one device layer further includes a second device layer and a third device layer; and after the first device layer is formed, the vertically stacking at least one device layer in sequence on the backplane to form a display unit further includes:
vertically stacking the second device layer and the third device layer in sequence on a side surface of the first device layer away from the backplane, to form the display unit.

In a preferred implementation, the performing etching inwardly from a side surface of the display unit away from the backplane to construct a cathode electrical connection channel and at least one anode electrical connection channel includes:
performing, through patterned dry etching, preliminary deep etching layer by layer from the side surface of the display unit away from the backplane to the inside; and
performing, through patterned wet etching, deep etching on the display unit having been subjected to the preliminary deep etching, until the backplane is exposed to form the at least one anode electrical connection channel, and until the corresponding N-type contact layer is exposed to form the cathode electrical connection channel.

In a preferred implementation, the performing etching inwardly from a side surface of the display unit away from the backplane to construct a cathode electrical connection channel and at least one anode electrical connection channel includes:
performing, through patterned dry etching, preliminary deep etching layer by layer from the side surface of the display unit away from the backplane to the inside; and
performing, through patterned wet etching, deep etching on the display unit having been subjected to the preliminary deep etching, until the backplane is exposed to form the cathode electrical connection channel and the at least one anode electrical connection channel.

In a preferred implementation, the performing metal filling on the cathode electrical connection channel and the at least one anode electrical connection channel to form a cathode electrical connection structure and at least one anode electrical connection structure includes:
passivating outer surfaces of the display unit and the backplane and inner walls of the cathode electrical connection channel and the at least one anode electrical connection channel to form a passivation layer, and providing at least one through hole through patterned etching, where the at least one through hole is provided between each of the at least one anode electrical connection structure and the corresponding P-type contact layer, and the at least one through hole is provided between the cathode electrical connection structure and the corresponding N-type contact layer; and
performing metal filling on the cathode electrical connection channel and the at least one anode electrical connection channel through sputtering, electroplating, chemical plating, or evaporation, to construct the cathode electrical connection structure and the at least one anode electrical connection structure.

According to a third aspect, a microdisplay is provided, including:
a drive backplane, including a drive circuit and an input/output interface;
a display region, arranged on the drive backplane, and including at least two display units according to any one of the implementations in the first aspect, where the at least two display units are arranged in an array; and
a peripheral common cathode, arranged around a periphery of the display region, and connected to the cathode electrical connection structure of each display unit respectively.

In a preferred implementation, the drive circuit is integrated into the backplane; and
corresponding to any pixel unit, the drive circuit includes at least one anode, and each of the at least one anode electrical connection structure is electrically connected to the corresponding anode.

In a preferred implementation, the microdisplay further includes an insulation layer and a transparent conductive layer attached to a surface of the display region in sequence from inside to outside, and the transparent conductive layer is connected to the peripheral common cathode; and
the insulation layer is provided with at least one hollow, and the cathode electrical connection structure is connected to the transparent conductive layer through the hollow of the insulation layer.

According to a fourth aspect, a discrete device is provided, including:
a discrete device backplane;
a device body, arranged on the discrete device backplane, and including at least two display units according to any one of any one of the implementations in the first aspect, where the at least two display units are arranged in an array; and
at least two pads, including one cathode pad and at least one anode pad, where at least a part of any anode pad and at least a part of the cathode pad are respectively embedded in the discrete device backplane, each of the at least one anode electrical connection structure is connected to the corresponding anode pad, and the cathode electrical connection structure is connected to the corresponding cathode pad.

### Compared with the prior art, this application has the following beneficial effects:

This application provides a pixel unit, a manufacturing method therefor, a microdisplay, and a discrete device. The pixel unit includes a backplane, a display unit, a cathode electrical connection structure, and at least one anode electrical connection structure, where the display unit is arranged on the backplane, and the cathode electrical connection structure and the at least one anode electrical connection structure are respectively embedded in the display unit from a side surface away from the backplane; the display unit includes at least one device layer, the at least one device layer is vertically stacked in sequence, each of the at least one device layer includes a P-type contact layer, a pixel layer, and an N-type contact layer stacked in sequence, and the P-type contact layer is located on a side of the device layer facing the backplane; and each of the at least one anode electrical connection structure is electrically connected to the P-type contact layer of the corresponding device layer, and the cathode electrical connection structure is electrically connected to the N-type contact layer of each of the at least one device layer respectively. In the pixel unit provided in this application, at least two device layers are vertically stacked and integrated in sequence on the backplane, to realize colored display. Compared with a pixel structure arranged and integrated in a horizontal direction, the pixel unit in this application occupies smaller space in the horizontal direction, so that ultra-high-density colored Micro-LED display is realized, thereby realizing a smaller display size at the same resolution or higher resolution at the same screen size. In addition, in this application, a plurality of device layers in a vertical direction share a same negative electrical connection structure, so that an area proportion of a light-emitting region is improved, thereby reducing impact of a size effect.

Further, a first anode electrical connection structure includes a first partial structure and a second partial structure connected in sequence, and an area of an end surface of the second partial structure is larger than an area of an end surface of the first partial structure, to form a first flange at a joint between the first partial structure and the second partial structure; and the pixel unit further includes a passivation layer, the passivation layer is partially attached to outer surfaces of the display unit and the backplane, the passivation layer is partially attached between the at least one anode electrical connection structure and the display unit, and the passivation layer is partially attached between the cathode electrical connection structure and the display unit. In the anode electrical connection structure in this application, a flange structure is constructed through a diameter change, to realize an electrical connection between the anode electrical connection structure and the P-type contact layer or between the cathode electrical connection structure and the N-type contact layer, thereby simplifying the structure, and reducing process difficulty.

In addition, this application provides a method for manufacturing a pixel unit. The manufacturing method includes: preparing a backplane; vertically stacking at least one device layer in sequence on the backplane to form a display unit, where each of the at least one device layer includes a P-type contact layer, a pixel layer, and an N-type contact layer stacked in sequence, and the P-type contact layer is located on a side of the device layer facing the backplane; performing etching inwardly from a side surface of the display unit away from the backplane to construct a cathode electrical connection channel and at least one anode electrical connection channel; and performing metal filling on the cathode electrical connection channel and the at least one anode electrical connection channel to form a cathode electrical connection structure and at least one anode electrical connection structure, where the cathode electrical connection structure is electrically connected to the N-type contact layer of each of the at least one device layer respectively, and each of the at least one anode electrical connection structure is electrically connected to the P-type contact layer of the corresponding device layer. In the method for manufacturing a pixel unit in this application, a solution of stacking first and then patterning is used, which avoids, by using a semiconductor process, high costs of aligned bonding, avoids an alignment precision deviation, and realizes stacking of pixels of smaller sizes in a process, thereby reducing process difficulty, and saving process costs.

It should be noted that, only at least one of the foregoing technical effects needs to be achieved in this application.

### BRIEF DESCRIPTION OF THE DRAWINGS

FIG. 1 is a top view of a pixel unit in Embodiment 1;
FIG. 2 is a cross-sectional view of an A-B section in FIG. 1;
FIG. 3 is a top view of a minimum light-emitting unit included in a discrete device in Embodiment 1 and Embodiment 3;
FIG. 4 is a cross-sectional view of a C-D section in FIG. 3;
FIG. 5 is a cross-sectional view of the C-D section when a sacrificial layer is included in FIG. 3;
FIG. 6 is a top view of a microdisplay;
FIG. 7 to FIG. 9 are schematic diagrams of three exemplary circuit structures included in a backplane in Embodiment 1; and
FIG. 10 is a schematic diagram of a circuit structure of each device layer.

### Reference numerals:

100-pixel unit, 10-drive backplane, 20-display unit, 30-cathode electrical connection structure, 31-third partial structure, 32-fourth partial structure, 33-fifth partial structure, 40-first device layer, 41-first bonding layer, 42-first P-type contact layer, 43-first pixel layer, 44-first N-type contact layer, 50-second device layer, 51-second bonding layer, 511-functional layer, 512-second bonding layer body, 52-second P-type contact, 53-second pixel layer, 54-second N-type contact layer, 60-third device layer, 61-third bonding layer, 62-third P-type contact layer, 63-third pixel layer, 64-third N-type contact layer, 71-first anode electrical connection structure, 711-first partial structure, 712-second partial structure, 713-first flange, 72-second anode electrical connection structure, 721-second flange, 73-third anode electrical connection structure, 731-third flange, 80-passivation layer, 81-fixing portion, 200-microdisplay, 210-drive backplane, 211-input/output interface, 220-display region, 230-peripheral common cathode, 240-insulation layer, 250-transparent conductive layer, 300-discrete device, 310-discrete device backplane, 320-device body, 330-cathode pad, 340-first anode pad, 350-second anode pad, and 360-third anode pad.

### DETAILED DESCRIPTION

To make the objectives, technical solutions, and advantages of this application clearer, the following clearly and completely describes the technical solutions in embodiments of this application with reference to the accompanying drawings in the embodiments of this application. Apparently, the described embodiments are only some rather than all of the embodiments of this application. All other embodiments obtained by a person skilled in the art based on the embodiments of this application without creative efforts fall within the protection scope of this application.

In the description of this application, it should be understood that orientation or position relationships indicated by the terms such as "upper", "lower", "inner", and "outer" are based on orientation or position relationships shown in the accompanying drawings, and are used only for ease and brevity of illustration and description of this application, rather than indicating or implying that the mentioned apparatus or component needs to have a particular orientation or needs to be constructed and operated in a particular orientation. Therefore, such terms should not be construed as limiting of this application. In addition, the terms "first" and "second" are used for descriptive purposes only and are not to be construed as indicating or implying relative importance or implicitly indicating the number of technical features indicated. Therefore, a feature defined by "first" or "second" may explicitly or implicitly include one or more features. In the description of this application, unless otherwise stated, "a plurality of" means two or more than two.

In the description of this application, it should be noted that, unless otherwise explicitly specified or defined, the terms such as "install", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediary, or internal communication between two components. A person of ordinary skill in the art may understand the specific meanings of the foregoing terms in this application according to specific situations.

### Embodiment 1

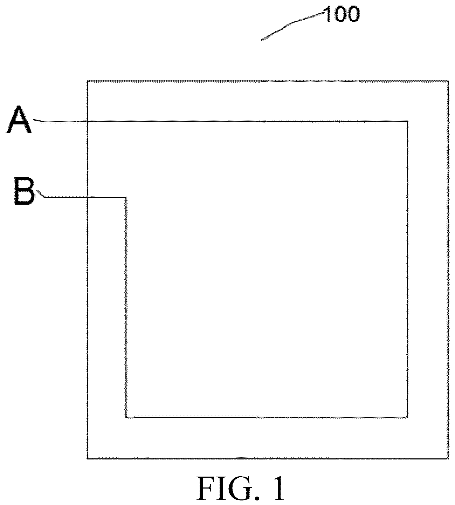

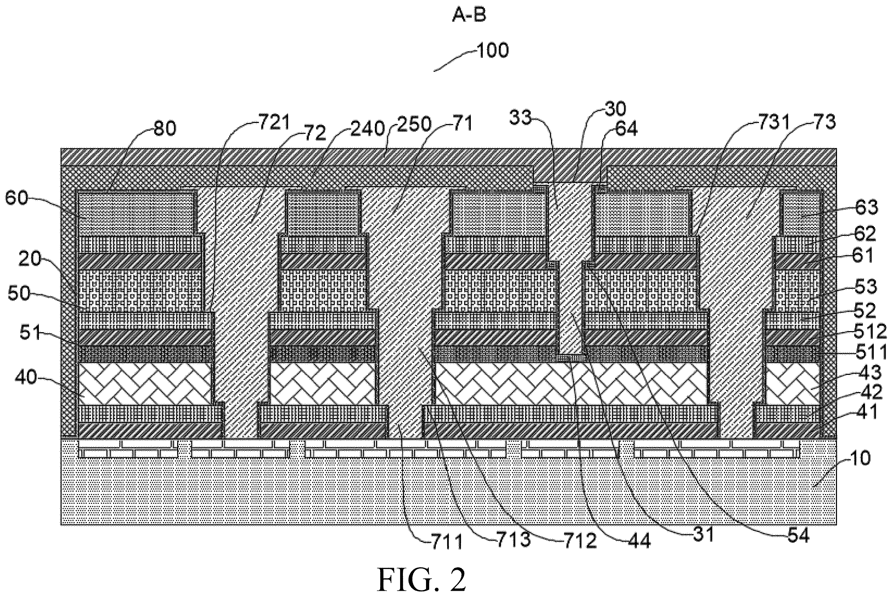

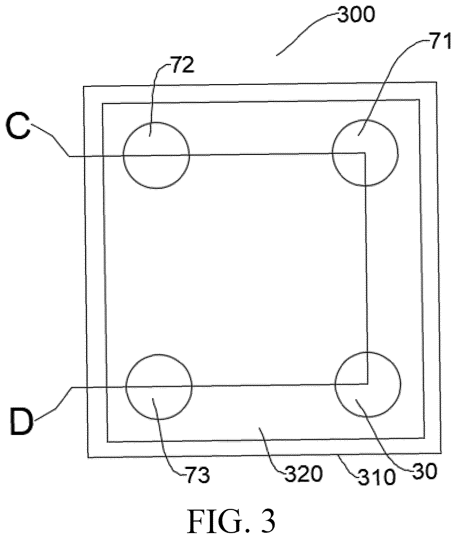

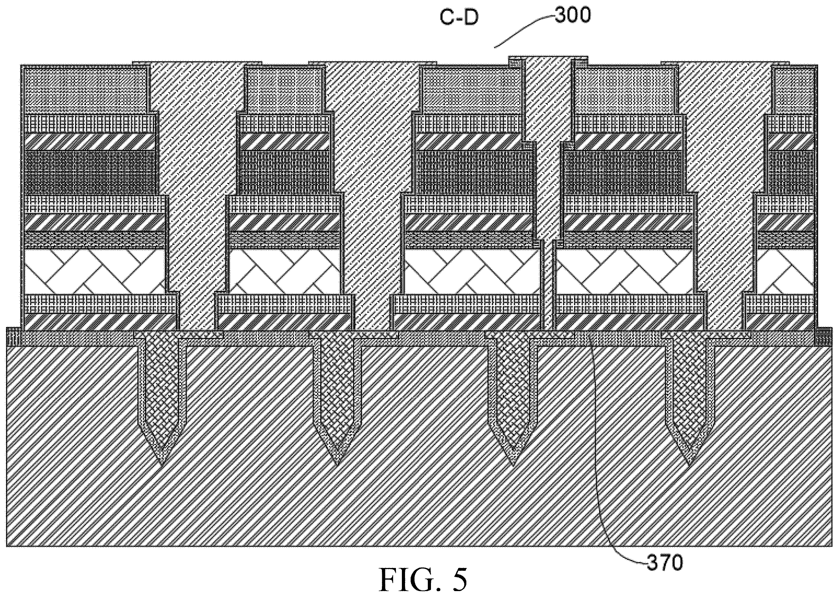

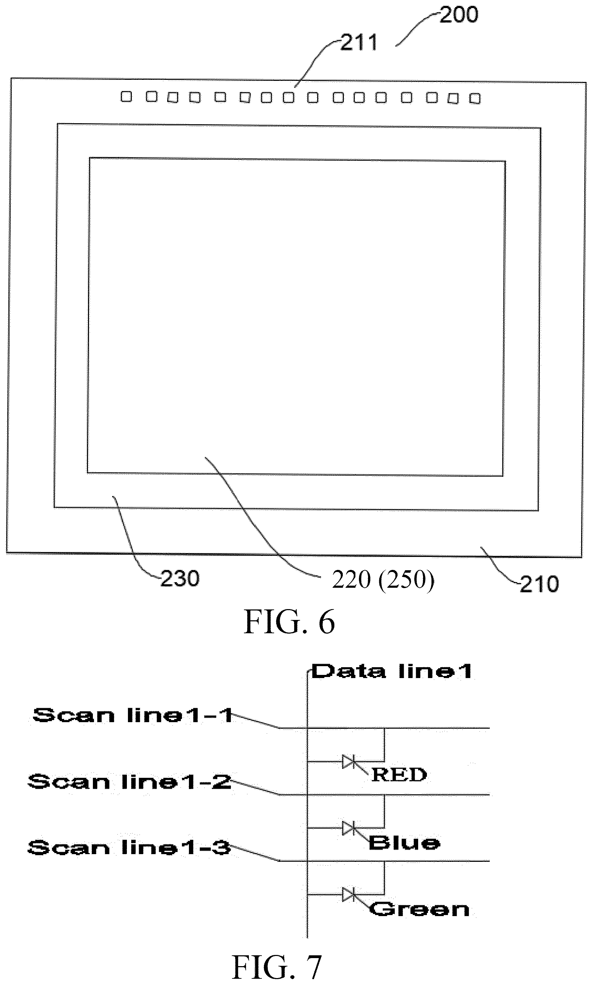

As shown in FIG. 1 and FIG. 2, this embodiment provides a pixel unit 100. The pixel unit may be used as a minimum light-emitting unit of a discrete device 300 shown in FIG. 3 to FIG. 5, or may be used as a minimum light-emitting unit of a microdisplay 200 shown in FIG. 6.

Referring to FIG. 2, the pixel unit 100 includes a backplane 10, a display unit 20, a cathode electrical connection structure 30, and at least one anode electrical connection structure. The display unit 20 is arranged on the backplane 10, and the cathode electrical connection structure 30 and the at least one anode electrical connection structure are respectively embedded in the display unit 20 from a side surface away from the backplane 10. Each of the at least one anode electrical connection structure is connected to the backplane 10.

The display unit 20 includes at least one device layer, and the at least one device layer is vertically stacked in sequence in a direction perpendicular to the backplane 10, to form a wafer level vertical stack pixel (WLVSP). Each of the at least one device layer includes a P-type contact layer, a pixel layer, and an N-type contact layer stacked in sequence, and the P-type contact layer is located on a side of the device layer facing the backplane 10. Each of the at least one anode electrical connection structure is electrically connected to the P-type contact layer of the corresponding device layer, and the cathode electrical connection structure is electrically connected to the N-type contact layer of each of the at least one device layer respectively. Therefore, preferably, a quantity of anode electrical connection structures included in the pixel unit in this embodiment corresponds to a quantity of device layers.

A quantity of device layers included in the display unit 20 is not limited in this embodiment, and may be one, two, three, or even more. When the quantity of device layers is not less than two, light-emitting compound epitaxial layers respectively included in any two device layers may be the same or different. When the light-emitting compound epitaxial layers included in the any two device layers are the same, brightness improvement of a light source of a same color is realized, or a spare redundant device layer is formed to improve the yield of the pixel unit. When the light-emitting compound epitaxial layers included in the any two device layers are different, colored display, for example, full colored display such as display of pixels of three primary colors: red, green, and blue, is realized.

For ease of description, in this embodiment, an example in which the pixel unit 100 is the pixels of the three primary colors: red, green, and blue is used as an example for further exemplary description. The display unit 20 includes a first device layer 40 that emits red light, a second device layer 50 that emits green light, and a third device layer 60 that emits blue light.

It should be noted that, each of the at least one device layer in this embodiment may be of a common pattern such as a quadrilateral, a hexagon, an octagon, or a circle, or a combination of patterns. This is not further limited in this embodiment.

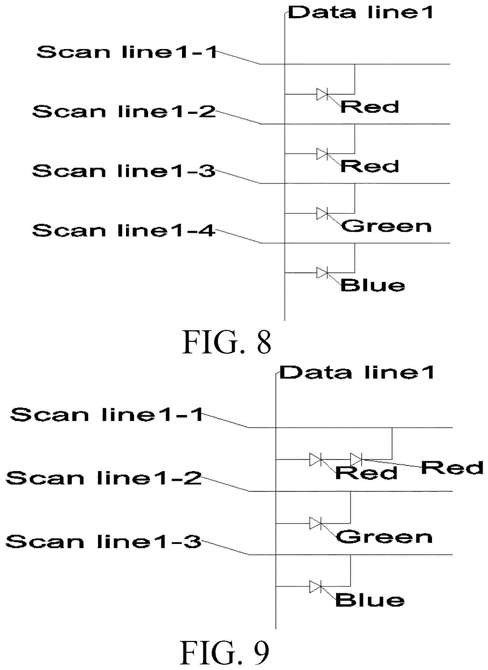

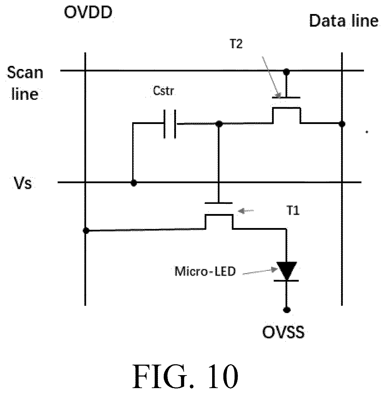

Specifically, the backplane 10 is a passive backplane or an active backplane into which a drive circuit is integrated. When the pixel unit is used in the microdisplay, the backplane 10 is preferably an active backplane. A drive circuit is provided with at least one anode, and an active drive backplane and a semi-active drive backplane including one or more of a thin film transistor (TFT), low-temperature polysilicon (LTPS), a CMOS integrated circuit, or a high electron mobility transistor (HEMT). For example, a CMOS integrated circuit backplane is selected, and top metal is provided on surfaces of anodes corresponding to R, G, and B respectively. A circuit diagram of a drive circuit of the CMOS integrated circuit backplane is shown in FIG. 7 to FIG. 9. FIG. 8 and FIG. 9 respectively show that two red-emitting device layers are stacked first and then a green-emitting device layer and a blue-emitting device layer are stacked, where the two red-emitting device layers may be connected in parallel or series. A circuit of each device layer may include an active, a passive, or a semi-passive control circuit. An exemplary circuit is shown in FIG. 10. It should be noted that, the circuit diagram in this embodiment is only a simple schematic diagram. The at least one anode in this embodiment may be arranged on a same straight line, arranged in a triangularly stacked form, or arranged in an array form. Any anode is located in the middle or at an edge of the drive backplane 10. This is not limited in this embodiment. When the pixel unit is used in the discrete device, the backplane is preferably a passive backplane. The backplane is preferably made of materials such as a PCB, sapphire, glass, and Si. The passive backplane is connected to a power supply by using a downstream encapsulation process.

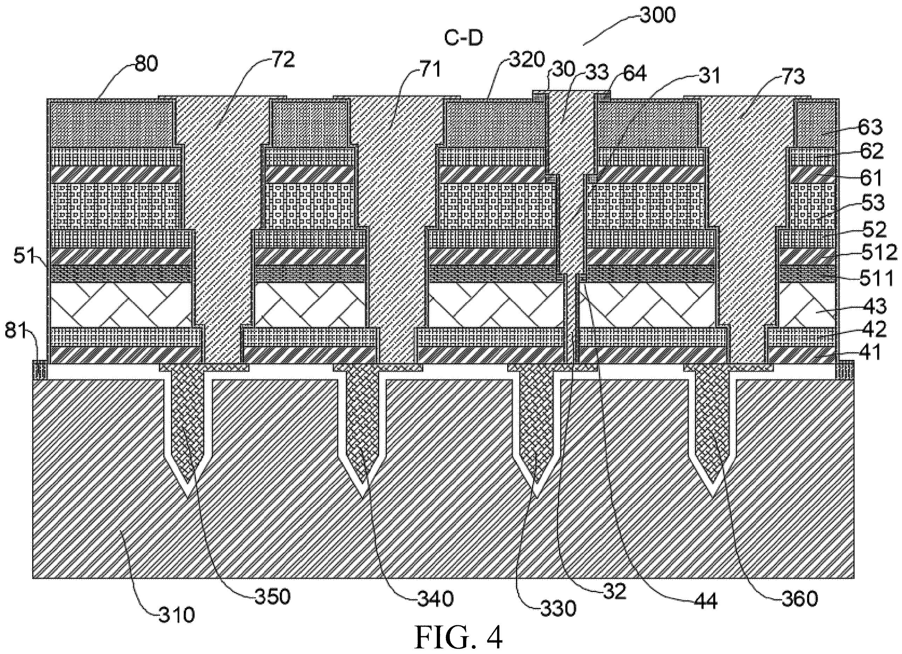

As further shown in FIG. 2 and FIG. 4, the first device layer 40 includes a first bonding layer 41, a first P-type contact layer 42, a first pixel layer 43, and a first N-type contact layer 44 stacked in sequence, and the first P-type contact layer 42 is located on a side of the first device layer 40 close to the backplane 10; the second device layer 50 is stacked on a side surface of the first device layer 40 away from the backplane 10, the second device layer 50 includes a second bonding layer 51, a second P-type contact layer 52, a second pixel layer 53, and a second N-type contact layer 54 stacked in sequence, and the second bonding layer 51 is connected to the first pixel layer 43; and the third device layer 60 is stacked on a side surface of the second device layer 50 away from the first device layer 40, the third device layer 60 includes a third bonding layer 61, a third P-type contact layer 62, a third pixel layer 63, and a third N-type contact layer 64 stacked in sequence, and the third bonding layer 61 is connected to the second pixel layer 53.

Preferably, both the second bonding layer 51 and the third bonding layer 61 are made of transparent bonding materials, to facilitate penetration of light. The transparent bonding material may be a transparent dielectric, for example, an organic transparent dielectric such as SU8; or an inorganic transparent dielectric such as SiO₂, Si₃N₄, or sapphire; or a semiconductive transparent material such as ITO, GaAs, GaP, or GaN.

Any of the foregoing P-type contact layers includes Ohmic contact and Schottky contact; may be made of a transparent conductive material such as ITO, or may be made of a stack or an alloy of a metal material such as Au, Ni, Ag, Mg, Be, or Zn; and is preferably made of ITO. The N-type contact layer is made of a stack and an alloy of one or more of Cr, Al, Ni, Ti, Au, Ge, Au, ITO, or ZnO, for example, AuGeNiAu. Preferably, any P-type contact layer is formed by coating ITO on a first compound semiconductor wafer through evaporation, sputtering, or the like. In addition, preferably, a thickness of the ITO film is 500 nm, and the Ohmic contact is formed by high-temperature annealing at 500°C in an N₂ environment.

Preferably, surface roughening treatment is performed on a surface of the N-type contact layer, including randomly or regularly distributed structures such as pits and tapers.

Preferably, the first pixel layer 43 is an AlGaInP or InGaN red-emitting compound epitaxial layer, the second pixel layer 53 is an InGaN green-emitting compound epitaxial layer, and the third pixel layer 63 is an InGaN blue-emitting compound epitaxy epitaxial layer.

Preferably, the second bonding layer 51 includes a functional layer 511 and a second bonding layer body 512, and the functional layer 511 is arranged between the second bonding layer body 512 and the first pixel layer 43. The functional layer 511 is at least one of an optical sieve, a Bragg reflection layer, an ODR structure, or a contact electrode. Preferably, the functional layer is a filter material, is arranged on the first N-type contact layer 44, and may be an organic colored glue or a stack of inorganic silicon oxide and titanium oxide thin films. The functional layer has a characteristic of allowing only red light wavelengths to pass through.

Corresponding to the first device layer 40, the second device layer 50, and the third device layer 60, the pixel unit 100 further includes a first anode electrical connection structure 71, a second anode electrical connection structure 72, and a third anode electrical connection structure 73, and all the three anode electrical connection structures are connected to the backplane 10 and are electrically connected to the P-type contact layers of the corresponding device layers. In other words, the first anode electrical connection structure 71 is electrically connected to the first P-type contact layer 42, the second anode electrical connection structure 72 is electrically connected to the second P-type contact layer 52, and the third anode electrical connection structure 73 is electrically connected to the third P-type contact layer 62.

Specifically, the first anode electrical connection structure 71 includes a first partial structure 711 and a second partial structure 712 connected in sequence. The first partial structure 711 is embedded in the first bonding layer 41 and the first P-type contact layer 42, and an end of the first partial structure 711 is connected to the backplane 10. The second partial structure 712 is partially embedded in the first pixel layer 43, and the second partial structure 712 is electrically connected to the first P-type contact layer 42. An area of an end surface of the second partial structure 712 is larger than an area of an end surface of the first partial structure 711, to form a first flange 713 at a joint between the first partial structure 711 and the second partial structure 712; and the first flange 713 is connected to the first P-type contact layer 42. Certainly, a flange structure may also be formed at a joint between the first anode electrical connection structure 71 and the second P-type contact layer 52 or the third P-type contact layer 62, to improve structural stability between the first anode electrical connection structure 71 and each device layer. However, it should be noted that, on the premise that the first device layer 40 and the second device layer are different compound epitaxial layers, when the first flange 713 and the first P-type contact layer 42 are in an electrically connected state, the first anode electrical connection structure 71 is in an insulated state from the P-type contact layers of the remaining device layers. Certainly, when any two device layers have a same compound epitaxial layer, any two flanges arranged in anode electrical connection structures may be electrically connected to corresponding P-type contact layers respectively. Similarly, the second anode electrical connection structure 72 includes a second flange 721, and the second flange 721 is electrically connected to the second P-type contact layer 52; and the third anode electrical connection structure 73 includes a third flange 731, and the third flange 731 is electrically connected to the third P-type contact layer 62.

The first N-type contact layer 44, the second N-type contact layer 54, and the third N-type contact layer 64 each are of a protruding structure, the first N-type contact layer 44 is embedded in the second bonding layer 51, and the second N-type contact layer 54 is embedded in the third bonding layer 61. Preferably, the first N-type contact layer 44, the second N-type contact layer 54, and the third N-type contact layer 64 are located in a vertical direction of the same backplane 10. To be specific, the third N-type contact layer 64 is located directly above the second N-type contact layer 54, and the second N-type contact layer 54 is located directly above the first N-type contact layer 44, to facilitate construction of the cathode electrical connection structure, and reduce process difficulty. Further, projections of the first N-type contact layer 44, the second N-type contact layer 54, and the third N-type contact layer 64 on the backplane 10 are semicircles with a same center, and radii of the semicircles increase from the first N-type contact layer 44 to the third N-type contact layer 64.

In a specific implementation, the cathode electrical connection structure 30 includes a third partial structure 31, the third partial structure 31 is embedded in the second device layer 72, and an end of the third partial structure 31 is connected to the first N-type contact layer. In the structure, when the pixel unit is used in the microdisplay, the backplane 10 is not provided with a cathode, and the cathode is arranged on a periphery or a surface of the display unit.

Based on this, in another optional implementation, the cathode electrical connection structure 30 further includes a fourth partial structure 32, one end of the fourth partial structure 32 is connected to the backplane 10, and an other end of the fourth partial structure 32 passes through the first device layer 71 and is connected to the third partial structure 31. When the pixel unit 100 is used in the microdisplay, the fourth partial structure 32 is in an insulated state from the backplane 10 and the first device layer 71. When the pixel unit 100 is used in the discrete device, the fourth partial structure 32 is insulated from only the first device layer 71.

Further, the cathode electrical connection structure 30 further includes a fifth partial structure 33 connected to the third partial structure 31, and the fifth partial structure 33 is embedded in the third device layer 60; an area of an end surface of the fifth partial structure 33 is larger than an area of an end surface of the third partial structure 31, to form a fourth flange 34 at a joint between the fifth partial structure 33 and the third partial structure 31; and the fourth flange 4 is connected to the second N-type contact layer 54.

Based on the foregoing structure, the pixel unit 100 further includes a passivation layer 80. The passivation layer 80 is made of a transparent insulation material. The passivation layer 80 is partially attached to outer surfaces of the display unit 20 and the backplane 10, the passivation layer 80 is partially attached between the at least one anode electrical connection structure and the display unit 20, and the passivation layer 80 is partially attached between the cathode electrical connection structure 30 and the display unit 20. The passivation layer 80 is provided with at least one through hole, the at least one through hole is provided between each of the at least one anode electrical connection structure and the corresponding P-type contact layer, and the at least one through hole is provided between the cathode electrical connection structure 30 and the corresponding N-type contact layer.

Corresponding to the foregoing pixel unit 100, this embodiment further provides a method for manufacturing a pixel unit. The method includes the following steps.

S1: Prepare a backplane.

S2: Vertically stack at least one device layer in sequence on the backplane to form a display unit.

Each of the at least one device layer includes a P-type contact layer, a pixel layer, and an N-type contact layer stacked in sequence, and the P-type contact layer is located on a side of the device layer facing the backplane. Specifically, the at least one device layer includes the first device layer, and the at least one device layer includes the first device layer.

Further, the vertically stacking at least one device layer in sequence on the backplane to form a display unit includes the following steps.

S11: Plate a bonding material on a surface of the backplane and a surface of a P-type contact layer of a prepared first compound semiconductor wafer respectively and perform bonding to form a first bonding layer.

S12: Remove a substrate of the first compound semiconductor wafer and perform compound semiconductor thinning to expose a first N-type contact layer, where the first N-type contact layer is of a protruding structure.

Further, the at least one device layer further includes a second device layer and a third device layer.

As described above, the first compound semiconductor wafer has completed P-type Ohmic contact. The bonding material is preferably SiO₂, and SiO₂-SiO₂ bonding is implemented. Specifically, a silicon oxide film with a flat surface is coated on the first compound semiconductor wafer that has completed the P-type Ohmic contact, where the silicon oxide film has a silicon oxide surface roughness Ra less than 7 nm and a film thickness of 10 nm to 10000 nm. When it is necessary to enhance bonding force, a Si layer of 1 to 15 nm may be coated on the surface.

After the first device layer is formed, step S1 further includes the following step.

S13: Vertically stack the second device layer and the third device layer in sequence on a side surface of the first device layer away from the backplane, to form the display unit. Certainly, stacking manners of the second device layer and the third device layer are consistent with that of the first bonding layer. Details are not described herein again.

As described above, the first compound semiconductor wafer (red-emitting epitaxial wafer) is used for the first device layer, a second compound semiconductor wafer (green-emitting epitaxial wafer) is used for the second device layer, and a third compound semiconductor wafer (blue-emitting epitaxial wafer) is used for the third device layer.

It should be noted that, a compound of the first compound semiconductor wafer belongs to an AlGaInP red-emitting system, the substrate of the first compound semiconductor wafer is preferably N-GaAs, and a structure of the first compound semiconductor wafer is shown in Table 1 below.

**Table 1**

| Layer name | Material |
|---|---|
| P contact | P-GaAs |
| MQW | AlGaInP |
| N contact | N-AlGaInP |
| Etch Stop | N-AlGaInP |
| Substrate | N-GaAs |

Compounds of the second compound semiconductor wafer and the third compound semiconductor wafer belong to an InGaN system, substrates of the second compound semiconductor wafer and the third compound semiconductor wafer are Si and GaN respectively, and corresponding structures of the second compound semiconductor wafer and the third compound semiconductor wafer are shown in Table 2 and Table 3 below.

**Table 2**

| Layer name | Material |
|---|---|
| P contact | P-GaAs |
| MQW | InGaN&GaN |
| N contact | GaN |
| Etch Stop | AlN&GaN |
| Substrate | Si |

**Table 3**

| Layer name | Material |
|---|---|
| P contact | P-GaN |
| MQW | InGaN&GaN |
| N contact | GaN |
| Etch Stop | InGaN |
| Substrate | GaN |

S3: Perform etching inwardly from a side surface of the display unit away from the backplane to construct a cathode electrical connection channel and at least one anode electrical connection channel.

Specifically, step S3 includes following steps.

S31: Perform, through patterned dry etching, preliminary deep etching layer by layer from the side surface of the display unit away from the backplane to the inside.

S32: Perform, through patterned wet etching, deep etching on the display unit having been subjected to the preliminary deep etching, until the backplane is exposed to form the at least one anode electrical connection channel, and until the corresponding N-type contact layer is exposed to form the cathode electrical connection channel.

S33: Perform, through patterned wet etching, deep etching on the display unit having been subjected to the preliminary deep etching, until the backplane is exposed to form the cathode electrical connection channel and the at least one anode electrical connection channel.

As described above, after S31 is completed, S32 or S33 is performed.

It should be noted that, when the method is used to manufacture a microdisplay and the backplane is not provided with a corresponding cathode, step S32 is performed. When the method is used to manufacture a discrete device, the backplane is provided with a cathode pad. In this case, step S33 is performed. The cathode electrical connection channel extends to the backplane, to facilitate a connection between a subsequently constructed cathode electrical connection structure and the cathode pad.

S4: Perform metal filling on the cathode electrical connection channel and the at least one anode electrical connection channel to form a cathode electrical connection structure and at least one anode electrical connection structure.

The cathode electrical connection structure is electrically connected to the N-type contact layer of each of the at least one device layer respectively, and each of the at least one anode electrical connection structure is electrically connected to the P-type contact layer of the corresponding device layer.

Specifically, step S4 includes the following steps.

S41: Passivate outer surfaces of the display unit and the backplane and inner walls of the cathode electrical connection channel and the at least one anode electrical connection channel to form a passivation layer, and provide at least one through hole through patterned etching, where the at least one through hole is provided between each of the at least one anode electrical connection structure and the corresponding P-type contact layer, and the at least one through hole is provided between the cathode electrical connection structure and the corresponding N-type contact layer. In other words, corresponding to step S33, when the cathode electrical connection channel extends to the backplane, the passivation layer on the surface of the backplane corresponding to the cathode electrical connection channel is provided with a through hole.

S42: Perform metal filling on the cathode electrical connection channel and the at least one anode electrical connection channel through sputtering, electroplating, chemical plating, or evaporation, to construct the cathode electrical connection structure and the at least one anode electrical connection structure.

In conclusion, this embodiment provides a pixel unit, a manufacturing method therefor, a microdisplay, and a discrete device. The pixel unit includes a backplane, a display unit, a cathode electrical connection structure, and at least one anode electrical connection structure, where the display unit is arranged on the backplane, and the cathode electrical connection structure and the at least one anode electrical connection structure are respectively embedded in the display unit from a side surface away from the backplane; the display unit includes at least one device layer, the at least one device layer is vertically stacked in sequence, each of the at least one device layer includes a P-type contact layer, a pixel layer, and an N-type contact layer stacked in sequence, and the P-type contact layer is located on a side of the device layer facing the backplane; and each of the at least one anode electrical connection structure is electrically connected to the P-type contact layer of the corresponding device layer, and the cathode electrical connection structure is electrically connected to the N-type contact layer of each of the at least one device layer respectively. In the pixel unit provided in this embodiment, at least two device layers are vertically stacked and integrated in sequence on the backplane, to realize colored display. Compared with a pixel structure arranged and integrated in a horizontal direction, the pixel unit in this embodiment occupies smaller space in the horizontal direction, so that ultra-high-density colored Micro-LED display is realized, thereby realizing a smaller display size at the same resolution or higher resolution at the same screen size. In addition, in this application, a plurality of device layers in a vertical direction share a same negative electrical connection structure, so that an area proportion of a light-emitting region is improved, thereby reducing impact of a size effect.

Further, a first anode electrical connection structure includes a first partial structure and a second partial structure connected in sequence, and an area of an end surface of the second partial structure is larger than an area of an end surface of the first partial structure, to form a first flange at a joint between the first partial structure and the second partial structure; and the pixel unit further includes a passivation layer, the passivation layer is partially attached to outer surfaces of the display unit and the backplane, the passivation layer is partially attached between the at least one anode electrical connection structure and the display unit, and the passivation layer is partially attached between the cathode electrical connection structure and the display unit. In the anode electrical connection structure in this embodiment, a flange structure is constructed through a diameter change, to realize an electrical connection between the anode electrical connection structure and the P-type contact layer or between the cathode electrical connection structure and the N-type contact layer, thereby simplifying the structure, and reducing process difficulty.

In addition, this embodiment provides a method for manufacturing a pixel unit. The manufacturing method includes: preparing a backplane; vertically stacking at least one device layer in sequence on the backplane to form a display unit, where each of the at least one device layer includes a P-type contact layer, a pixel layer, and an N-type contact layer stacked in sequence, and the P-type contact layer is located on a side of the device layer facing the backplane; performing etching inwardly from a side surface of the display unit away from the backplane to construct a cathode electrical connection channel and at least one anode electrical connection channel; and performing metal filling on the cathode electrical connection channel and the at least one anode electrical connection channel to form a cathode electrical connection structure and at least one anode electrical connection structure, where the cathode electrical connection structure is electrically connected to the N-type contact layer of each of the at least one device layer respectively, and each of the at least one anode electrical connection structure is electrically connected to the P-type contact layer of the corresponding device layer. In the pixel manufacturing method in this embodiment, a solution of stacking first and then patterning is used, which avoids, by using a semiconductor process, high costs of aligned bonding, avoids an alignment precision deviation, and realizes stacking of pixels of smaller sizes in a process, thereby reducing process difficulty, and saving process costs.

It should be noted that, only at least one of the foregoing technical effects needs to be achieved in this embodiment.

### Embodiment 2

Based on Embodiment 1, this embodiment further provides a microdisplay 200. As shown in FIG. 2 and FIG. 6, the microdisplay 200 includes:
a drive backplane 210, including a drive circuit and an input/output interface 211;
a display region 220, arranged on the drive backplane 210, and including at least two display units 20 in Embodiment 1, where the at least two display units 100 are arranged in an array;
a peripheral common cathode 230, arranged around a periphery of the display region 220, and connected to the cathode electrical connection structure of each display unit 100 respectively;
an insulation layer 240, arranged on a surface of the display region 220; and
a transparent conductive layer 250, arranged on an outer side surface of the insulation layer 240, where the insulation layer 240 is provided with at least one hollow, and the cathode electrical connection structure 30 is connected to the transparent conductive layer 250 through the hollow of the insulation layer 240; and the transparent conductive layer 250 is connected to the peripheral common cathode 230, to realize a connection between each pixel unit and a cathode electrode.

In the microdisplay 200 provided in this embodiment, based on technical effects of the pixel unit provided in Embodiment 1, the construction of the cathode electrode is implemented by arranging the transparent conductive layer, which simplifies an etching step in the pixel unit and also avoids impact on a device layer in an etching process, thereby effectively improving the yields of the pixel unit and the microdisplay.

### Embodiment 3

As shown in FIG. 3 to FIG. 5, based on Embodiment 1, this embodiment further provides a discrete device 300. The discrete device 300 includes:
a discrete device backplane 310;
a device body 320, arranged on the discrete device backplane 310, and including at least two display units 20 in Embodiment 1, where the at least two display units 20 are arranged in an array; and
at least two pads, including one cathode pad 330 and at least one anode pad, where at least a part of the cathode pad 330 and at least a part of any anode pad are respectively embedded in the discrete device backplane 310, each of the at least one anode electrical connection structure is connected to the corresponding anode pad, and the cathode electrical connection structure 30 is connected to the corresponding cathode pad 330.

Specifically, the at least one anode pad includes a first anode pad 340 connected to the first device layer 40, a second anode pad 350 connected to the second device layer 50, and a third anode pad 360 connected to the third device layer 60.

In a preferred solution, the device body 320 is arranged separately from the discrete device backplane 310, and the at least two pads are arranged separately from the discrete device backplane 310. Preferably, the passivation layer 81 includes a fixing portion 81 or the fixing portion 81, where the fixing portion 81 is connected to the discrete device backplane 310, to connect the device body 320 to the discrete device backplane 310. Specifically, the preferred manner is implemented by pre-arranging a sacrificial layer 370 between the discrete device backplane 310 and the device body 320 and between the discrete device backplane 310 and at least one pad, and then removing the sacrificial layer 370.

Corresponding to the discrete device, this embodiment further provides a method for manufacturing a discrete device. The method includes the following steps.

S10: Prepare a discrete device backplane. Specifically, S10 includes the following steps.

S101: Perform etching to form at least four cavities on the prepared discrete device backplane.

S102: Plate a sacrificial layer on the discrete device backplane provided with the at least four cavities. The sacrificial layer is formed by performing coating, thermal oxidation, wet oxidation, or the like on a surface of the discrete device backplane by using a silicon oxynitride film.

S103: Construct at least four pads on a side of the discrete device backplane coated with the sacrificial layer, where each pad is partially embedded in the corresponding cavity, and the at least four pads include one cathode pad and at least three anode pads.

The pad in this embodiment is a metal pad, and may be an alloy or a stack of one or more of gold, titanium, tungsten, aluminum, or platinum. A preparation manner of the pad includes thermal evaporation, sputtering, electroplating, chemical plating, or the like. The pad may be solid or hollow.

S20: Vertically stack at least one device layer in sequence on the discrete device backplane to form a display unit and construct a cathode electrical connection structure and at least one anode electrical connection structure.

Step S20 includes the following steps.

S201: Perform, through patterned dry etching, preliminary deep etching layer by layer from the side surface of the display unit away from the discrete device backplane to the inside.

S202: Perform, through patterned wet etching, deep etching on the display unit having been subjected to the preliminary deep etching, until the discrete device backplane is exposed to form a cathode electrical connection channel and at least one anode electrical connection channel.

S203: Passivate outer surfaces of the device body and the discrete device backplane and inner walls of the cathode electrical connection channel and the at least one anode electrical connection channel to form a passivation layer, and provide at least one through hole through patterned etching, where the at least one through hole is provided between each of the at least one anode electrical connection structure and a corresponding P-type contact layer, and the at least one through hole is provided between the cathode electrical connection structure and the discrete device backplane.

It should be noted that, the discrete device backplane is partially covered by the passivation layer. A fixing portion is formed at a joint between the device body and the discrete device backplane on the passivation layer. The fixing portion realizes a connection between the device body and the discrete device backplane.

S30: Remove the sacrificial layer to obtain the discrete device.

Specifically, the sacrificial layer is etched on a side surface of the discrete device backplane on which the passivation layer is not coated, to separate the at least four pads from the discrete device backplane; and an etching rate ratio of the sacrificial layer to the discrete device backplane is greater than 10:1, and an etching rate ratio of the sacrificial layer to the passivation layer is greater than 10:1. In addition, preferably, a gap between the discrete device backplane and the device body after etching ranges from 100 nm to 1000 nm, and preferably ranges from 300 nm to 500 nm.

In conclusion, based on technical effects of the pixel unit in Embodiment 1, the discrete device in this embodiment is connected to an external circuit based on at least two pads. In this way, when the discrete device is encapsulated to a target backplane for an electrical connection, eutectic metal soldering or the like can be avoided to avoid performance impact on the discrete device, and the process can be simplified. In addition, in this embodiment, the device body is arranged separately from the discrete device backplane, and the at least four pads are arranged separately from the discrete device backplane; and the pixel-level discrete device further includes an insulation support structure, and the insulation support structure covers the device body and a part of the discrete device backplane. The insulation support structure is arranged in the pixel discrete device, to realize structural stability when the device body is arranged separately from the backplane and convenience during later use. In addition, the discrete device backplane can be used cyclically under the structure, so that costs are effectively reduced.

All the foregoing exemplary technical solutions may be arbitrarily combined to form an exemplary embodiment of this application. In other words, any multiple embodiments can be combined to meet requirements of different application scenarios, which are all within the protection scope of this application. Details are not described herein again.

It should be noted that, the foregoing descriptions are merely preferred embodiments of this application, but are not intended to limit this application. Any modification, equivalent replacement, or improvement made within the spirit and principle of this application shall fall within the protection scope of this application.

## Claims

1. A pixel unit, comprising a backplane, a display unit, a cathode electrical connection structure, and at least one anode electrical connection structure, wherein the display unit is arranged on the backplane, and the cathode electrical connection structure and the at least one anode electrical connection structure are respectively embedded in the display unit from a side surface away from the backplane;
the display unit comprises at least one device layer, the at least one device layer is vertically stacked in sequence, each of the at least one device layer comprises a P-type contact layer, a pixel layer, and an N-type contact layer stacked in sequence, and the P-type contact layer is located on a side of the device layer facing the backplane; and
each of the at least one anode electrical connection structure is electrically connected to the P-type contact layer of the corresponding device layer, and the cathode electrical connection structure is electrically connected to the N-type contact layer of each of the at least one device layer respectively.

2. The pixel unit according to claim 1, wherein each of the at least one anode electrical connection structure is connected to the backplane;
the at least one anode electrical connection structure comprises a first anode electrical connection structure, and the first anode electrical connection structure comprises a first partial structure and a second partial structure connected in sequence;
the at least one device layer comprises a first device layer, the first device layer comprises a first bonding layer, a first P-type contact layer, a first pixel layer, and a first N-type contact layer stacked in sequence, and the first P-type contact layer is located on a side of the first device layer close to the backplane; and
the first partial structure is embedded in the first bonding layer and the first P-type contact layer, the second partial structure is partially embedded in the first pixel layer, and the second partial structure is electrically connected to the first P-type contact layer.

3. The pixel unit according to claim 2, wherein an area of an end surface of the second partial structure is larger than an area of an end surface of the first partial structure, to form a first flange at a joint between the first partial structure and the second partial structure; and
the first flange is connected to the first P-type contact layer.

4. The pixel unit according to claim 2, wherein the at least one anode electrical connection structure further comprises a second anode electrical connection structure;
the display unit further comprises a second device layer, the second device layer is stacked on a side surface of the first device layer away from the backplane, the second device layer comprises a second bonding layer, a second P-type contact layer, a second pixel layer, and a second N-type contact layer stacked in sequence, and the second bonding layer is connected to the first pixel layer; and
the second anode electrical connection structure comprises a second flange, and the second flange is connected to the second P-type contact layer.

5. The pixel unit according to claim 4, wherein the second N-type contact layer is arranged directly above the first N-type contact layer.

6. The pixel unit according to claim 4, wherein the first N-type contact layer is of a protruding structure, and the first N-type contact layer is embedded in the second bonding layer.

7. The pixel unit according to claim 6, wherein the cathode electrical connection structure comprises a third partial structure, the third partial structure is embedded in the second device layer, and an end of the third partial structure is connected to the first N-type contact layer.

8. The pixel unit according to claim 7, wherein the cathode electrical connection structure further comprises a fourth partial structure, one end of the fourth partial structure is connected to the backplane, and an other end of the fourth partial structure passes through the first device layer and is connected to the third partial structure.

9. The pixel unit according to claim 4, wherein the second bonding layer comprises a second bonding layer body and a functional layer, and the functional layer is arranged between the second bonding layer body and the first pixel layer.

10. The pixel unit according to claim 7, wherein the at least one anode electrical connection structure further comprises a third anode electrical connection structure;
the display unit further comprises a third device layer, the third device layer is stacked on a side surface of the second device layer away from the first device layer, the third device layer comprises a third bonding layer, a third P-type contact layer, a third pixel layer, and a third N-type contact layer stacked in sequence, and the third bonding layer is connected to the second pixel layer; and
the third anode electrical connection structure comprises a third flange, and the third flange is connected to the third P-type contact layer.

11. The pixel unit according to claim 10, wherein the cathode electrical connection structure further comprises a fifth partial structure connected to the third partial structure, and the fifth partial structure is embedded in the third device layer;
an area of an end surface of the fifth partial structure is larger than an area of an end surface of the third partial structure, to form a fourth flange at a joint between the third partial structure and the fifth partial structure; and
the fourth flange is connected to the second N-type contact layer.

12. The pixel unit according to claim 11, wherein the second N-type contact layer is of a protruding structure, and the second N-type contact layer is embedded in the third bonding layer.

13. The pixel unit according to claim 12, wherein both the second bonding layer and the third bonding layer are made of transparent materials.

14. The pixel unit according to any one of claims 1 to 13, wherein the pixel unit further comprises a passivation layer, the passivation layer is partially attached to outer surfaces of the display unit and the backplane, the passivation layer is partially attached between the at least one anode electrical connection structure and the display unit, and the passivation layer is partially attached between the cathode electrical connection structure and the display unit.

15. The pixel unit according to claim 14, wherein the passivation layer is provided with at least one through hole, and the at least one through hole is provided between each of the at least one anode electrical connection structure and the corresponding P-type contact layer, and between the cathode electrical connection structure and the corresponding N-type contact layer.

16. The pixel unit according to claim 14, wherein the passivation layer is made of a transparent insulation material.

17. The pixel unit according to any one of claims 10 to 13, 15, and 16, wherein the first pixel layer is an AlGaInP or InGaN red-emitting compound epitaxial layer, the second pixel layer is an InGaN green-emitting compound epitaxial layer, and the third pixel layer is an InGaN blue-emitting compound epitaxy epitaxial layer.

18. A method for manufacturing a pixel unit, comprising:
preparing a backplane;
vertically stacking at least one device layer in sequence on the backplane to form a display unit, wherein each of the at least one device layer comprises a P-type contact layer, a pixel layer, and an N-type contact layer stacked in sequence, and the P-type contact layer is located on a side of the device layer facing the backplane;
performing etching inwardly from a side surface of the display unit away from the backplane to construct a cathode electrical connection channel and at least one anode electrical connection channel; and
performing metal filling on the cathode electrical connection channel and the at least one anode electrical connection channel to form a cathode electrical connection structure and at least one anode electrical connection structure, wherein the cathode electrical connection structure is electrically connected to the N-type contact layer of each of the at least one device layer respectively, and each of the at least one anode electrical connection structure is electrically connected to the P-type contact layer of the corresponding device layer.

19. The method according to claim 18, wherein the at least one device layer comprises a first device layer; and the vertically stacking at least one device layer in sequence on the backplane to form a display unit comprises:
plating a bonding material on a surface of the backplane and a surface of a P-type contact layer of a prepared first compound semiconductor wafer respectively and performing bonding to form a first bonding layer; and
removing a substrate of the first compound semiconductor wafer and performing compound semiconductor thinning to expose a first N-type contact layer, wherein the first N-type contact layer is of a protruding structure.

20. The method according to claim 19, wherein the at least one device layer further comprises a second device layer and a third device layer; and after the first device layer is formed, the vertically stacking at least one device layer in sequence on the backplane to form a display unit further comprises:
vertically stacking the second device layer and the third device layer in sequence on a side surface of the first device layer away from the backplane, to form the display unit.

21. The method according to claim 18, wherein the performing etching inwardly from a side surface of the display unit away from the backplane to construct a cathode electrical connection channel and at least one anode electrical connection channel comprises:
performing, through patterned dry etching, preliminary deep etching layer by layer from the side surface of the display unit away from the backplane to the inside; and
performing, through patterned wet etching, deep etching on the display unit having been subjected to the preliminary deep etching, until the backplane is exposed to form the at least one anode electrical connection channel, and until the corresponding N-type contact layer is exposed to form the cathode electrical connection channel.

22. The method according to claim 18, wherein the performing etching inwardly from a side surface of the display unit away from the backplane to construct a cathode electrical connection channel and at least one anode electrical connection channel comprises:
performing, through patterned dry etching, preliminary deep etching layer by layer from the side surface of the display unit away from the backplane to the inside; and
performing, through patterned wet etching, deep etching on the display unit having been subjected to the preliminary deep etching, until the backplane is exposed to form the cathode electrical connection channel and the at least one anode electrical connection channel.

23. The method according to claim 21 or 22, wherein the performing metal filling on the cathode electrical connection channel and the at least one anode electrical connection channel to form a cathode electrical connection structure and at least one anode electrical connection structure comprises:
passivating outer surfaces of the display unit and the backplane and inner walls of the cathode electrical connection channel and the at least one anode electrical connection channel to form a passivation layer, and providing at least one through hole through patterned etching, wherein the at least one through hole is provided between each of the at least one anode electrical connection structure and the corresponding P-type contact layer, and the at least one through hole is provided between the cathode electrical connection structure and the corresponding N-type contact layer; and
performing metal filling on the cathode electrical connection channel and the at least one anode electrical connection channel through sputtering, electroplating, chemical plating, or evaporation, to construct the cathode electrical connection structure and the at least one anode electrical connection structure.

24. A microdisplay, comprising:
a drive backplane, comprising a drive circuit and an input/output interface;
a display region, arranged on the drive backplane, and comprising at least two display units according to any one of claims 1 to 7, and 9 to 17, wherein the at least two display units are arranged in an array; and
a peripheral common cathode, arranged around a periphery of the display region, and connected to the cathode electrical connection structure of each display unit respectively.

25. The microdisplay according to claim 24, wherein the drive circuit is integrated into the backplane; and
corresponding to any pixel unit, the drive circuit comprises at least one anode, and each of the at least one anode electrical connection structure is connected to the corresponding anode.

26. The microdisplay according to claim 25, wherein the microdisplay further comprises an insulation layer and a transparent conductive layer attached to a surface of the display region in sequence from inside to outside, and the transparent conductive layer is connected to the peripheral common cathode; and
the insulation layer is provided with at least one hollow, and the cathode electrical connection structure is connected to the transparent conductive layer through the hollow of the insulation layer.

27. A discrete device, comprising:
a discrete device backplane;
a device body, arranged on the discrete device backplane, and comprising at least two display units according to any one of claims 1 to 17, wherein the at least two display units are arranged in an array; and
at least two pads, comprising one cathode pad and at least one anode pad, wherein at least a part of any anode pad and at least a part of the cathode pad are respectively embedded in the discrete device backplane, each of the at least one anode electrical connection structure is connected to the corresponding anode pad, and the cathode electrical connection structure is connected to the corresponding cathode pad.
